(19) Europäisches Patentamt
European Patent Office
Office européen des brevets

(11) **EP 3 375 006 B1**

(12) **EUROPÄISCHE PATENTSCHRIFT**

(45) Veröffentlichungstag und Bekanntmachung des Hinweises auf die Patenterteilung:
**12.05.2021  Patentblatt 2021/19**

(21) Anmeldenummer: **16798404.6**

(22) Anmeldetag: **14.11.2016**

(51) Int Cl.:
*H01J 37/34* *(2006.01)*     *C23C 14/34* *(2006.01)*

(86) Internationale Anmeldenummer:
**PCT/EP2016/001891**

(87) Internationale Veröffentlichungsnummer:
**WO 2017/080672 (18.05.2017 Gazette 2017/20)**

(54) **SPUTTER-ANORDNUNG UND - VERFAHREN ZUR OPTIMIERTEN VERTEILUNG DES ENERGIEFLUSSES**

SPUTTERING ARRANGEMENT AND SPUTTERING METHOD FOR OPTIMIZED DISTRIBUTION OF THE ENERGY FLOW

SYSTÈME DE PULVÉRISATION CATHODIQUE ET PROCÉDÉ PERMETTANT UNE RÉPARTITION OPTIMISÉE DU FLUX ÉNERGÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.11.2015   US 201562254451 P**

(43) Veröffentlichungstag der Anmeldung:
**19.09.2018   Patentblatt 2018/38**

(73) Patentinhaber: **Oerlikon Surface Solutions AG, Pfäffikon**
**8808 Pfäffikon (CH)**

(72) Erfinder:
• **KRASSNITZER, Siegfried**
  **6800 Feldkirch (AT)**
• **LENDI, Daniel**
  **9472 Grabs (CH)**
• **KURAPOV, Denis**
  **8880 Walenstadt (CH)**

(74) Vertreter: **Misselhorn, Hein-Martin**
**Patent- und Rechtsanwalt**
**Donaustrasse 6**
**85049 Ingolstadt (DE)**

(56) Entgegenhaltungen:
**DE-A1-102011 018 363     DE-C1- 19 651 615**
**US-A1- 2014 248 100**

**Beschreibung**

Die vorliegende Erfindung bezieht sich auf eine Anordnung und ein Verfahren zum Abscheiden von PVD-Schichtsystemen mittels kathodischer Zerstäubung, üblicherweise auch Sputtern genannt. Die Erfindung umfasst die Anwendung von Pulsen hoher Leistungsdichte auf eine Magnetron Entladung und die optimale Verteilung des Energieflusses auf mehrere Magnetron Komponenten einer Beschichtungsanlage.

**Stand der Technik**

Bei Beschichtungsprozessen mittels Sputtern wird im Allgemeinen mindestens ein Target, welches als Kathode eingeschaltet ist, mit Ionen aus einem Plasma beschossen, was dazu führt, dass Material vom Target abgetragen wird. Üblicherweise werden die Ionen mit Hilfe eines elektrischen Feldes in Richtung Targetoberfläche beschleunigt. Ausserdem wird in der Regel hinter dem als Kathode geschalteten Target ein zusätzliches Magnetfeld angeordnet, damit Elektronen im Plasma auf eine Spiralbahn gezwungen werden und über der zu sputternden Targetoberfläche kreisen. Dabei erhöht sich die Zahl der Stösse pro Elektron erheblich, dergestalt dass eine höhere Ionisation über die Targetoberfläche in zumindest einem bestimmten Bereich erreicht wird, was zu einem erhöhten Sputterabtrag auf dem Target (im Folgenden auch Sputtertarget oder Sputterkathode genannt) unmittelbar unter diesem Bereich führt. Dabei entstehen die für das Magnetronsputtern typischen Erosionsgräben, und der Bereich, in dem die Elektronen kreisen, d.h. über den entstehenden Erosionsgräben, wird Racetrack genannt.

High Power Impuls Sputtering, HiPIMS, stellt eine besondere Art des Sputterns bzw. des Magnetronsputterns dar. Dabei wird eine hohe bis sehr hohe Sputterleistungsdichte (im Folgenden auch Leistungsdichte genannt) angewandt. Die Anwendung einer hohen Sputterleistungsdichte geht mit einer hohen Stromdichte einher, welche zu einer Ionisation des gesputterten Materials führt. Von HiPIMS-Prozessen spricht man ab einer Sputterleistungsdichte von grösser 300 W/cm$^2$ oder ab einer Stromdichte von grösser 0.5 A/cm$^2$ Beim konventionellen Magnetron Sputtern beträgt die Leistungsdichte Werte kleiner als 100 W/cm$^2$. Die Fläche ist dabei durch den Magnetron Racetrack, welcher dem Spezialisten bekannt ist, definiert.

In diesem Kontext sind dann Leistungsdichten (Sputterleistungsdichten) von 100 W/cm$^2$ oder grösser, insbesondere von 300 W/cm$^2$ oder grösser, als hohe Leistungsdichten zu verstehen.

Um ein Überhitzen des gesputterten Targetmaterials, üblicherweise auch Sputtertarget genannt, bei Sputterprozessen, in denen solche hohe Leistungsdichten eingesetzt werden, insbesondere bei HiPIMS, zu vermeiden, muss die Sputterleistungsdichte pulsartig aufgebracht werden. In EP2272080B1 wird die pulsartige Aufbringung einer Sputterleistungsdichte beschrieben. Zu diesem Zweck wird ein Kondensator auf eine hohe Spannung aufgeladen und über einen Schalter dem Magnetron zugeführt. Durch die hohe Spannung und bei Anwesenheit von Sputtergas wird eine Magnetronentladung gezündet und der Sputterstrom steigt solange der Kondensator die Spannung aufrechterhalten kann. Mit dieser in EP2272080B1 beschriebener Methode kann man Sputterpulse mit einer Dauer von 10 μs bis ca. 200 μs erzeugen. In DE102011018363 A1 und US 2014/248100A1 werden Sputter-Anordnungen und Verfahren beschrieben, bei denen eine kombinierte Leistung von mehreren Generatoren auf Kathoden sequenziell und gepulst aufgebracht werden.

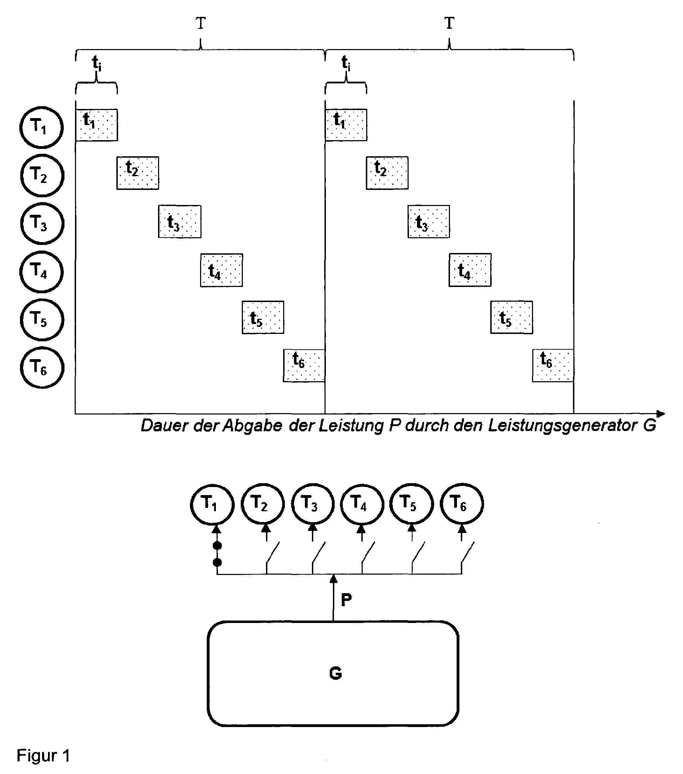

In WO/2012/143091 wird ein Verfahren zur Bereitstellung von sequenziell auf mehrere Sputtertargets, $T_i$, aufgebrachte Sputterleistungsdichten beschrieben. Es wird vorgeschlagen, eine Kathode in voneinander isolierten Teilkathoden aufzuteilen oder statt einer Kathode mehrere Kathoden zu verwenden und eine definierte Sputterleistung sequenziell nacheinander auf die Teilkathoden bzw. Kathoden aufzubringen, dergestalt, dass diese mit Leistungspulsen gespeist werden können. In diesem Zusammenhang ist die Sputterleistung die Leistung, welche von der verwendeten Leistungsversorgungseinrichtung bereitgestellt wird. Hierbei wird ein Sputterleistungsgenerator, G, auf eine Vielzahl von Kathoden oder Teilkathoden $T_i$ (in diesem Fall $T_1$, $T_2$, $T_3$, $T_4$, $T_5$ und $T_6$) angewandt, wobei Leistungsdichtepulse sequenziell auf diese Teilkathoden $T_i$ aufgebracht werden, ohne die Leistungsentnahme vom Sputterleistungsgenerator, G, zu unterbrechen, wobei jeweils ein Leistungsdichtepuls auf eine Teilkathode $T_i$ während einer entsprechenden Pulszeit $t_i$ aufgebracht wird, wie es beispielsweise in der Figur 1 für eine kontinuerliche Leistungsabgabe des Leistungsgenerators G während 2 Perioden (2 T) skizziert ist. Die Sputterleistungsdichte (oder wie bereits oben erwähnt auch einfach Leistungsdichte genannt) ermittelt sich in so einem Fall aus der Generatorleistung P geteilt durch die Racetrackfläche an der entsprechenden Sputterkathode $T_i$. Die mittlere aufgenommene Leistung, d.h. die mittlere Sputterleistung einer Sputterkathode, $Pav_i$, (bspw. in kW) ergibt sich aus der Sputterleistungsdichte (bspw. in kW/cm$^2$) x Racetrackfläche an der entsprechenden Sputterkathode (bspw. in cm$^2$) x Einschaltdauer (bspw. in s) x Schaltfrequenz (bspw. in s$^{-1}$).

In diesem Zusammenhang ist mit Einschaltdauer die Dauer der Wirkung eines Leistungpulses auf die Sputterkathode gemeint, d.h. die Pulszeit ti bei der entsprechenen Sputterkathode $T_i$ und die Schaltfrequenz als 1/T definiert wird.

Wird eine Vielzahl N > 2 von Sputterkathoden $T_i$ verwendet und jede Sputterkathode $T_i$ in einer wiederkehrenden Sequenz mit Sequenzdauer gleich einer Periode T mit gleicher, vorzugsweise konstanter Sputterleistung P vom Leistungsgenerator G (in diesem Sinne auch Pulsleistung P genannt) betrieben, wobei die Pulsleistung auf jede Sputterkathode $T_i$ möglichst ohne Zeitverzögerung nacheinander aufgebracht wird, und wobei jede Pulszeit $t_i$, während der die Pulsleistung auf die jeweilige Sputterkathode angelegt wird, gleich lang ist, dann ergibt sich die von einer Sputterkathode $T_i$ aufgenommene Sputterleistung, d.h. die mittlere Sputterleistung pro Sputterkathode $Pav_i$ zu:

$$Pavi = \qquad Pav = P / N \qquad\qquad Eq.\ 1$$

mit

$Pav_i =$ mittlere Sputterleistung pro Sputterkathode
$P =$ Leistung vom Generator
$N =$ Anzahl der Sputterkathoden

Für den Fall von ungleichen Pulszeiten pro Sputterkathode ($t_1 \neq t_{2...}$), aber ansonsten gleicher Betriebsweise (d.h. ansonsten mit Speisung der Sputterkathoden $T_i$ in wiederkehrender Sequenz mit Dauer der Frequenz gleich einer Periode T, ohne Unterbrechung der vorzugsweise konstante Sputterleistung vom Generator und ohne Zeitverzögerung zwischen des Aufbringens der Pulsleistung auf die jeweiligen Sputterkathoden während einer Periode T) gilt:

$$t_1 \neq t_{2...} \qquad\qquad Eq.\ 2$$

$$Pav_i P * t_i / T \qquad\qquad Eq.\ 3$$

$$T = \sum_{i=1}^{N} t_i \qquad\qquad Eq.\ 4$$

$$F = 1/T \qquad\qquad Eq.\ 5$$

mit

$Pav_i =$ mittlere Sputterleistung der jeweiligen Sputterkathode
$t_i =$ Einschaltzeit (Pulszeit) der jeweiligen Sputterkathode
$T =$ Dauer der Periode der jeweiligen wiederkehrenden Sequenz
$F =$ Frequenz, mit der die wiederkehrende Sequenz wiederholt wird

Mit i wird jede einzelne Sputterkathode der Sputteranordnung gemeint, d.h., wenn die Sputteranordnung eine Anzahl von N Kathoden umfasst, dann ist i jeweils 1, 2, 3, ... bis N.
Das HiPIMS-Verfahren wird bevorzugt zur Erzeugung von ionisiertem Materialdampf aus dem zu sputternden Material und Bildung von dünnen Schichten unter Anlegen einer negativen Substratvorspannung (Biasspannung) verwendet. Der Grad der Ionisation des ionisierten Materialdampfes hängt von der Stromdichte oder in diesem Fall von der Sputterleistungsdichte der Magnetronentladung ab. Es ist auch bekannt, dass bei hoher Ionisation der gesputterten Teilchen es zu einer Rückströmung der Ionen zum Sputtertarget (d.h. zur Sputterkathode) kommt und damit zu einer Abnahme der Beschichtungsrate.

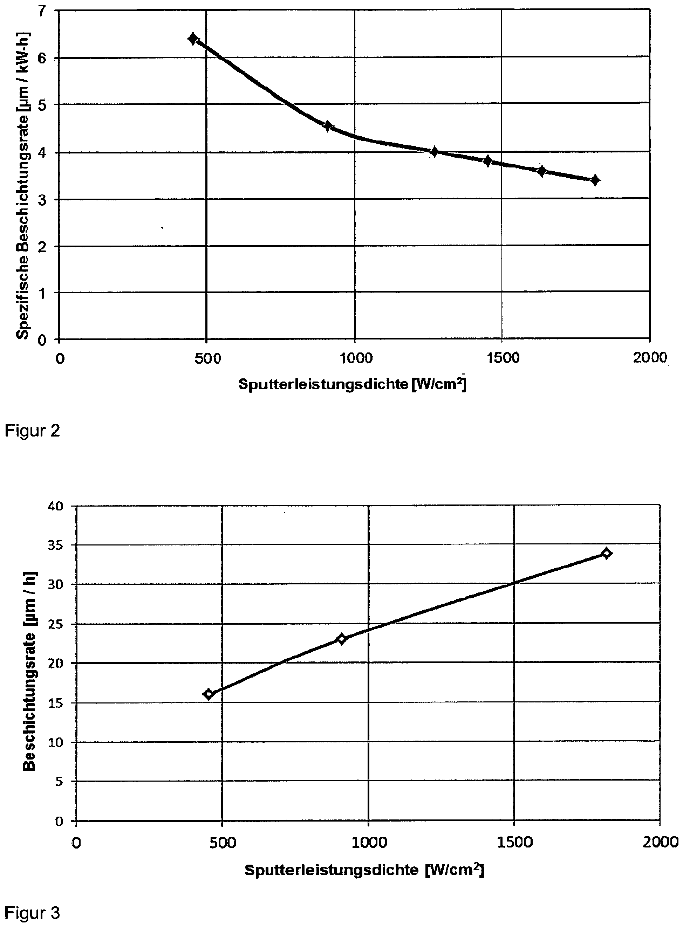

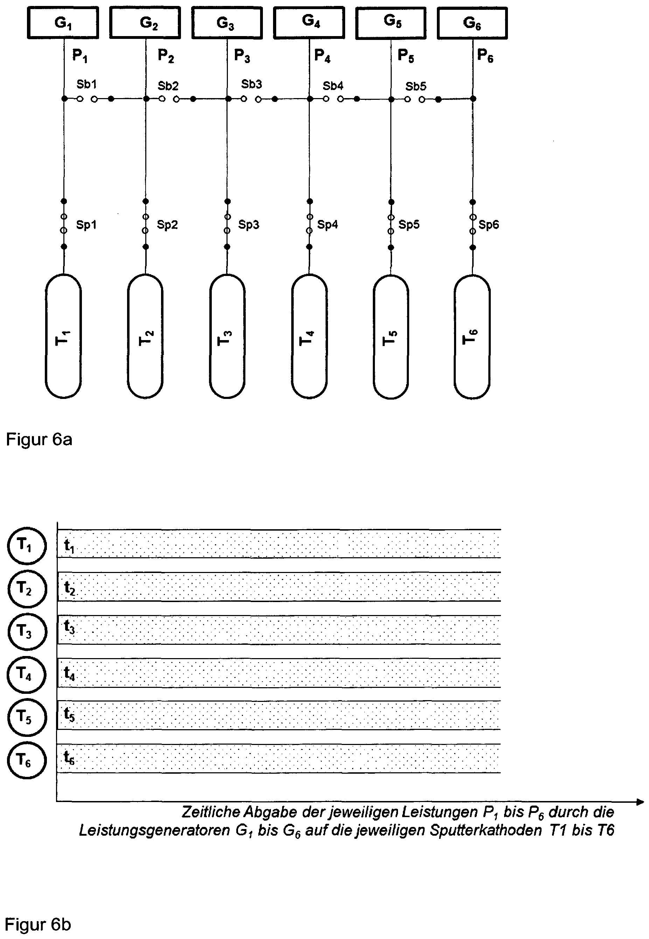

In der Figur 2 ist der Verlauf der spezifischen Beschichtungsrate in $\mu m/KW \cdot h$ in Abhängigkeit der eingebrachten Sputterleistungsdichte dargestellt. Die spezifische Beschichtungsrate kann als die Beschichtungsrate pro mittlere Sputterleistung angesehen werden, weil sie durch Schichtdicke pro Zeiteinheit (beispielsweise Beschichtungszeit) pro mittlere Sputterleistung definiert ist, wobei die mittlere Sputterleistung wiederum durch die Sputterleistungsdichte x Racetrackfläche pro Sputterkathode definiert ist, wie in Fig. 6 zu sehen ist:

$$R_{spezif.\_i} = R/Pav_i \qquad\qquad Eq.\ 6$$

mit

$R_{spezif.\_i}$ = spezifische Beschichtungsrate in $\mu$m/kW·h

$R$ = Beschichtungsrate in $\mu$m/h

$Pav_i$ = mittlere Sputterleistung der jeweiligen Sputterkathode

Die Daten von Figur 2 wurden an einer Titan Entladung (d.h. einer Sputterentladung mit Titan als Sputterkathodenmaterial) gemessen. Die spezifische Beschichtungsrate sinkt bei diesem Beispiel durch die Erhöhung der Sputterleistungsdichte von 500 W/cm$^2$ auf 1800 W/cm$^2$ auf ca. die Hälfte ab (von ca. 6.5 $\mu$m/kW·h bis ca. 3.5 $\mu$/kW·h). Das bedeutet, dass man bei Beschichtungsprozessen mit höheren Sputterleistungsdichten weniger produktiv ist.

Wie in WO/2012/143091 beschrieben und in Eq.1 ersichtlich ist, wird bei der Anwendung von Leistungspulsen, welche sequentiell und zeitlich gelichmässig auf mehrere Sputterkathoden in Reihenfolge eine nach der anderen aufgebracht werden, die mittlere Sputterleistung pro Sputterkathode durch die am Sputtergenerator oder an der Leistungsversorgungseinrichtung eingestellte Sputterleistung (auch Pulsleistung genannt) und die Anzahl der beteiligten Sputterkathoden bestimmt. Das bedeutet wiederum, dass man die am Leistungsgenerator G eingestellte Leistung P reduzieren kann, um absichtlich eine Reduktion der Sputterleistungsdichte zu erzielen, damit die spezifische Beschichtungsrate erhöht wird, indem dabei die mittlere Sputterleistung pro Sputterkathode $Pav_i$ zwingend reduziert wird, wenn ansonsten alle anderen eingestellten Parameter der Anordnung gleich (unverändert) bleiben. Dabei kommt es jedoch zur kontradiktorischen Situation, dass, obwohl die Beschichtungsrate pro mittlere Sputterleistung aufgrund der Verwendung einer geringeren Sputterleistungsdichte rechnerisch steigen soll, die mittlere Sputterleistung pro Sputterkathode selbst sinkt und daher auf diese Weise kein Produktivitätsgewinn erzielt werden kann. Das wird anhand der Figur 3 deutlicher erklärt.

Figur 3 zeigt den Verlauf der Beschichtungsrate in Abhängigkeit der Sputterleistungsdichte gemäss einer Anordnung mit 6 Teilkathoden wie in Fig. 1 dargestellt, unter Einbeziehung der spezifischen Beschichtungsrate von Titan in Abhängigkeit der Sputterleistungsdichte, wenn lediglich die am Leistungsgenerator eingestellte Pulsleistung P variiert wird, um dadurch die Sputterleistungsdichte (pro Sputterkathode) zu variieren. Da kann man deutlich feststellen, dass bei einer Verringerung der Sputterleistungsdichte durch die Reduzierung der Pulsleistung P in einer solchen HiPIMS-Anordnung die mittlere Sputterleistung so stark absinkt, dass die spezifische Beschichtungsrate auch absinkt, weil die Beschichtungsrate selbst stärker als die mittlere Sputterleistung absinkt.

Problematisch ist auch dabei, dass aufgrund der geringen Flexibilität zur Einstellung der Leistungsdichte (und dabei auch des Ionisierungsgrads) einer solchen HiPIMS-Anordnung auch eine geringe Flexibilität zur Abscheidung von Schichten mit unterschiedlichen Schichteigenschaften vorhanden ist, weil viele Schichteigenschaften durch die Sputterleistungsdichte und den Ionisierungsgrad, der zusätzlich auch vom Targetmaterial abhängt, beeinflusst werden. Ausserdem ist es sehr schwierig, mit einer solchen Anordnung die auf die am Leistungsgenerator eingestellte Sputterleistung bezogene Beschichtungsrate zu optimieren, um Produktivität zu gewinnen.

**Aufgabe der Erfindung**

Es ist nun Aufgabe der vorliegenden Erfindung, eine Sputteranordnung und ein Verfahren zur Durchführung von Beschichtungsprozessen mittels gepulstem Sputtern, insbesondere mittels Sputtern mit hohen Leistungsdichtepulsen bzw. mittels HiPIMS bereitzustellen, welches erlaubt die Sputterleistungsdichte zu variieren, ohne dass es zu einem Verlust der Produktivität führt.

**Lösung der Aufgabe gemäss der vorliegenden Erfindung**

Die Aufgabe wird dadurch gelöst, dass eine Sputter-Anordnung mit einer Vernetzung von Sputterleistungsgeneratoren $G_j$, welche jeweils eine Pulsleistung $P_j$ zur Verfügung stellen, erfindungsgemäss bereitgestellt wird.

Die vorliegende Erfindung betrifft eine Sputter-Anordnung, eine Vakuumbeschichtungsanlage und eine Methode zur Durchführung von HiPIMS-Beschichtungsverfahren, wobei die Sputter-Anordnung zumindest zwei verschiedene Verschaltungsmöglichkeiten aufweist, wobei durch die Umschaltung auf die zweite Verschaltungsmöglichkeit, bei zwei Sputter-Sub-Anordnung gleichzeitig mit hohen Leistungspulsen betreiben werden, ein Produktivitätsgewinn erreicht wird.

Die Erfindung wird im Detail anhand von folgenden Beispielen erklärt:

Eine Anzahl N von Sputterkathoden $T_i$ soll mit einer Anzahl n von Sputtergeneratoren (nachstehend auch Sputterleistungsgeneratoren genannt) $G_j$ verknüpft werden, um zu erreichen, dass das Ergebnis $Pav_i = P \times t_i / T$ für alle Werte von Leistung P, welche die Sputterleistungsdichte bestimmen, ein Optimum oder Maximum darstellt, wobei die Leistung P in diesem Beispiel als die Summe der von den jeweiligen Leistungsgeneratoren abgegebenen Leistungen $P_j$ definiert wird: $P = \sum_{j=1}^{n} Pj$.

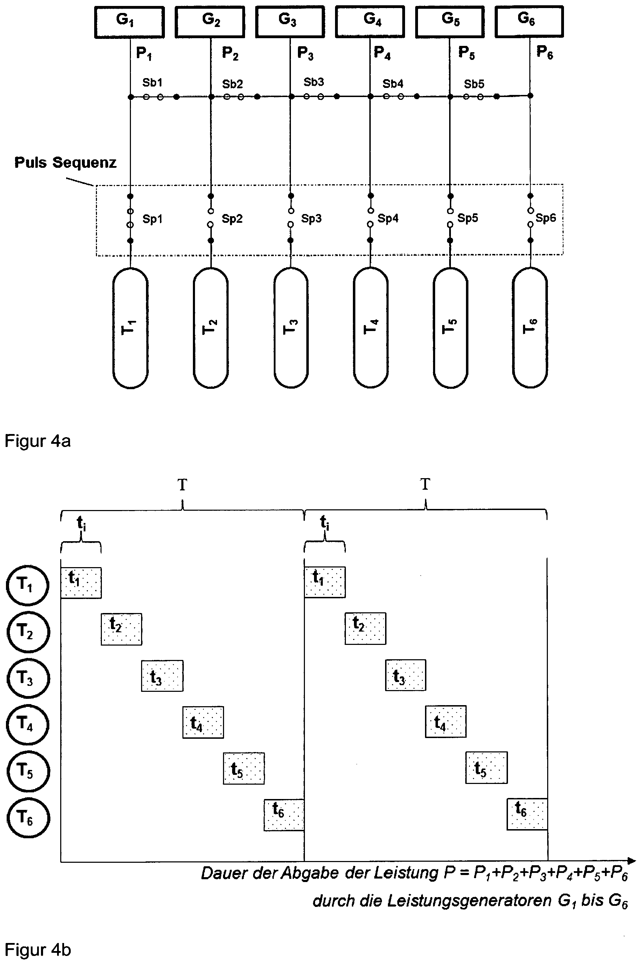

In der Figur 4a ist eine erfindungsgemässe Sputter-Anordnung exemplarisch gezeigt, welche eine Vernetzung von Sputtergeneratoren $G_j$ umfasst. Die zugehörige, zeitliche Verteilung der Sputterleistungspulsen $t_i$ ist für diese Sputter-Anordnung in Figur 4b dargestellt, wobei:

$P_j$ = Sputterleistung, welche durch den jeweiligen Leistungsgenerator $G_j$, in Fig. 4 ist n beispielweise gleich 6, d.h. der Koeffizient j variiert in diesem Beispiel von 1 bis 6

$Sb_j$ = Brückenschalter zur Schaltung der Leistungsausgabe $P_j$ des jeweiligen Leistungsgenerators $G_j$

$Sp_i$ = Pulsschalter zum sequenziellen Speisen der jeweiligen Sputterkathode $T_i$ (zum sequenziellen Aufbringen von Sputterleistung auf die jeweiligen Sputterkathoden $T_i$), in Fig. 4 ist N beispielweise gleich 6, d.h. der Koeffizient j variiert in diesem Beispiel von 1 bis 6, wobei jede Sputterkathode $T_i$ mit einer Sputterleistung P, welche in diesem Fall der Summe der Leistungsausgaben der Leistungsgeneratoren entspricht, eingespeist wird, d.h.

$$P = \sum_{j=1}^{n} Pj$$

In der in Figur 4a gezeigten Sputter-Anordnung wird die Leistungsausgabe der 6 Sputtergeneratoren singemäss durch die Brückenschalter dergestalt verschaltet, dass eine gesamte Sputterleistung P, welche die Summe der Leistungsausgaben $P_j$ der jeweiligen Leistungsgeneratoren $G_j$ zur Verfügung gestellt wird (d.h. $P = \sum_{j=1}^{n} Pj$ mit n = 6 dann P = $P_1$+$P_2$+$P_3$+$P_4$+$P_5$+$P_6$). Über eine Pulssequenzerzeugung durch bespielweise gesteuerte IGBT-Schalter Sp1 bis Sp6 kann eine Sequenz von Leistungspulsen wie in Fig. 4b dargestellt erzeugt werden. Die einzelnen Leistungspulse weisen eine Pulsleistung (Amplitude) P auf. Die Vielzahl von Leistungsgeneratoren wird unterbrechnungsfrei betrieben.
Bei gleicher Pulszeit, d.h. $t_i$ = $t_{i+1}$ (in diesem Beispiel dann $t_i$=$t_2$=$t_3$=$t_4$=$t_5$=$t_6$) und gleicher Leistungsausgabe der einzelnen Leistungsgeneratoren, d.h. $P_1$=$P_2$=$P_3$=$P_4$=$P_5$=$P_6$ gilt:

$$Pav_i = 6 \times P_j / 6 = P_j$$

$$P = 6 * Pg_j$$

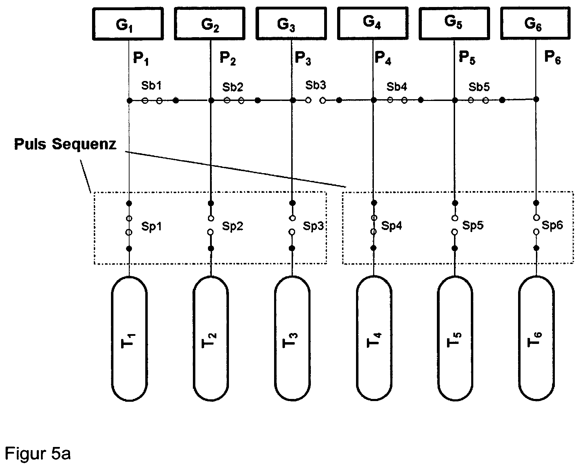

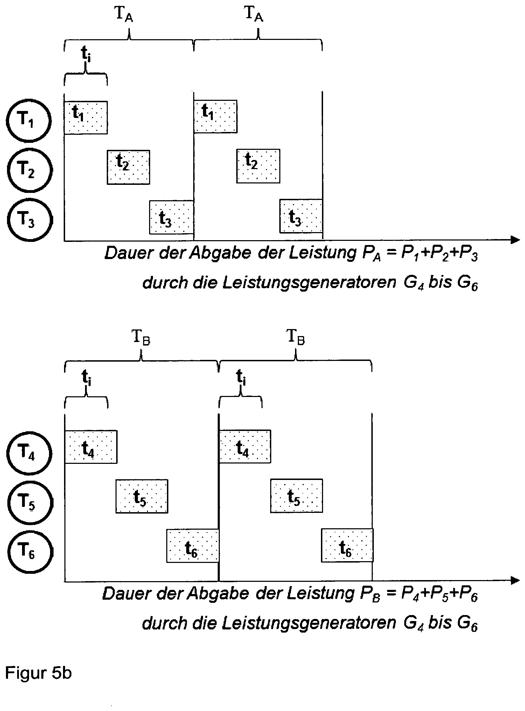

In der Fig. 5a, b wird die gleiche erfindungsgemässe Sputter-Anordnung wie in Fig. 4 gezeigt, aber in einer erfindungsgemäss weiteren Verschaltung der Brückenschalter dargestellt, bei der die Sputterkathoden in zwei separaten Sputter-Sub-Anordnungen betrieben werden.
Wie in Fig. 5a ersichtlich ist, werden durch Öffnen des Brückenschalters Sb3 die Leistungsgeneratoren in zwei Gruppen sinngemäß verschaltet, d.h. in diesem Beispiel werden drei von den Leistungsgeneratoren ($G_1$, $G_2$ und $G_3$) werden in einer ersten Sub-Anordnung A zur Bereitstellung einer ersten Pulsleistung $P_A$ = $P_1$+$P_2$+$P_3$ und die anderen drei Leistungsgeneratoren ($G_4$, $G_5$, $G_6$) in einer zweiten Sub-Anordnung B zur Bereitstellung einer zweiten Pulsleistung $P_B$ = $P_4$+$P_5$+$P_6$, sinngemäß verschaltet. In ähnlicher Weise werden jeweils drei von den Sputterkathoden zu der ersten Sub-Anordnung und die anderen drei Sputterkathoden zu der zweiten Sub-Anordnung zugänglich gemacht, dergestalt, dass beispielsweise die Sputterkathoden $T_1$, $T_2$ und $T_3$ mit der ersten Pulsleistung $P_A$ und die anderen drei Sputterkathoden $T_4$, $T_5$ und $T_6$ mit der zweiten Pulsleistung $P_B$ pulsmässig und sequenziell gespeist werden.
Die Beschaltung der IGBT-Schalter Sp1 bis Sp3 und Sp4 bis Sp6 kann nun auf diese Weise in völlig getrennten Pulssequenzen oder synchronen Pulssequenzen erfolgen mit gleichen oder unterschiedlichen Pulszeiten $t_i$ und auch mit gleichen oder unterschiedlichen Perioden $T_A$ und $T_B$. Es ist zu beachten, dass die Pulsleistungen $P_A$=$P_1$+$P_2$+$P_3$ und $P_B$=$P_4$+$P_5$+$P_6$ kleiner als die gesamte Pulsleistung P =$P_1$+$P_2$+$P_3$+$P_4$+$P_5$+$P_6$ sind. Damit wird bei der Verschaltung in zwei Sub-Anordnungen, wie in Figur 5 gezeigt, auf die Sputterkathoden $T_i$ im Vergleich zur Verschaltung der Sputter-Anordnung, wie in Figur 4 gezeigt, eine kleinere Sputterleistungsdichte pro Sputterkathode aufgebracht. Die mittlere Sputterleistung $Pav_i$ pro Sputterkathode in der Sub-Anordnung in Figur 5 bleibt jedoch gleich wie in der Sputter-Anordnung in Figur 4.
Erfindungsgemäss wird dann, gemäss der Erkenntnis aus Figur 2, die gesamte Beschichtungsrate mit der Verschaltung dieser zwei Sub-Anordnungen grösser als mit der Verschaltung einer einzigen Sputter-Anordnung, wie in Figur 4.

Bei gleicher Pulszeit $t_i$ der einzelnen Leistungspulsen $P_j$ auf die einzelnen Sputterkathoden $T_i$ (d.h. mit $t_1=t_2=t_3=t_4=t_5=t_6$) und gleicher abgegebener Leistung der einzelnen Leistungsgeneratoren $G_i$ ($P_1=P_2=P_3=P_4=P_5=P_6$) gilt:

$$Pav_{iA} = Pav_{iB} = n_A * P_j / n_A = n_B * P_j / n_B = 3 * P_i / 3 = P_i$$

$$Pav = P_j$$

$$\text{Pulsleistung in der A und B Sub-Anordnung} = P_A = P_B = 3 * Pj$$

Figur 6a, b zeigt eine dritte sinngemässe Verschaltung der erfinderischen Sputter-Anordnung, welche erfindungsgemäss auch wie bereits in der Figur 4 und in der Figur 5 verschaltet werden kann. Bei dieser Einstellung werden alle Brückenschalter geöffnet. Jede Sputterkathode $T_i$ wird einem einzelnen Leistungsgenerator zugeordnet. Die Sputterleistung Pc für jede Sputterkathode $T_i$ entspricht dann $P_j$. Damit ist die Sputterleistungsdichte weiter reduziert. Die mittlere Sputterleistung ist jedoch gleich wie in den beispielsweise bereits oben dargestellten Verschaltungen in Fig. 4 und Fig. 5. Gemäss der Erkenntnis wie in Fig. 2 dargestellt ist bei dieser dritten Verschaltung die Beschichtungsrate grösser verglichen mit jenen aus den Einstellungen in Fig. 4 und Fig. 5.

Bei gleicher Leistung $P_j$ der einzelnen Generatoren ($G_j$) gilt:

$$Pav = P_j$$

$$\text{Pulsleistung} = P_C = P_j$$

Aus den vorhergehenden Beschreibungen anhand einer erfinderischen Sputter-Anordnung von 6 Sputtergeneratoren und 6 Targets (Sputterkathoden) kann der Experte leicht eine Erweiterung auf eine Anzahl n von Generatoren und ebenfalls auf eine Anzahl N von Sputterkathoden ableiten, bei der $n \neq 6$ und/oder $N \neq 6$.

Beispiele für Beschichtungsraten:

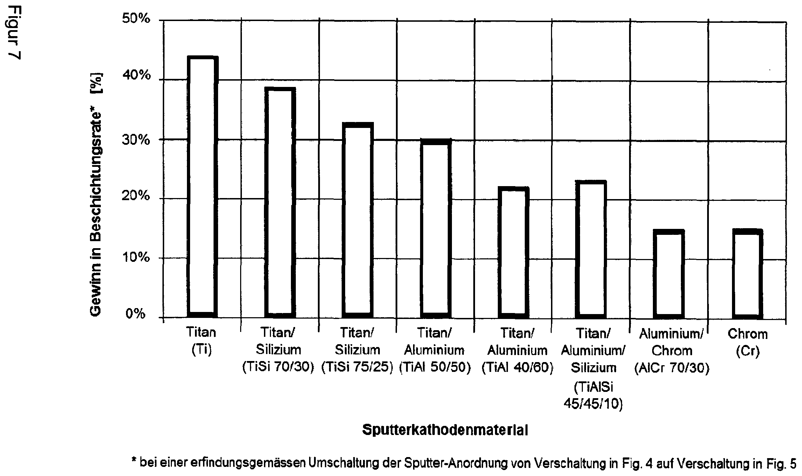

Figur 7 zeigt den Beschichtungsratengewinn bei Umschaltung der erfindungsgemässen Sputter-Anordnung von der Verschaltung in Figur 4 auf die Verschaltung in Figur 5. Es wurden unterschiedliche Sputtermaterialien in Sputterkathoden gemäss der Einstellungen in den Beispielen in Fig. 4 und Fig. 5 beschaltet und enstprechende Schichten wurden abgeschieden.

Die Sputterleistungsdichte betrug dabei im Falle der Verschaltung gemäss Fig. 4 1800W/cm$^2$ und im Falle der Verschaltung gemäss Fig. 5 900W/cm$^2$. Die mittlere Sputterleistung war in beiden Fällen gleich. Für alle Sputtermaterialien konnte eine Beschichtungsratensteigerung, wie in Fig. 7 gezeigt, festgestellt werden. Hätte man die Leistungsdichte in der Sputter-Anordnung mit der Verschaltung gemäss Fig. 4 reduziert, indem die Pulsleistung P reduziert würde, hätte man auch die Beschichtungsrate praktisch bis zur Hälfte reduziert und dabei kein Beschichtungsrategewinn, somit auch kein Produktivitätsgewinn.

**Legende der Figuren:**

- Figur 1 zeigt eine zeitliche Verteilung von Leistungspulsen (auch Sputterpulsen genannt) mit Pulsleistung P in einer Sputter-Anordnung mit sechs Teilkathoden (auch Sputterkathoden genannt) $T_1$ bis $T_6$. Die Leistungspulse werden sequenziell hintereinander auf die sechs Teilkathoden aufgebracht, ohne die Leistungsentnahme vom Sputtergenerator G zu unterbrechen, wobei $t_1$ ist die Pulszeit des während einer Periode T auf die erste Teilkathode $T_1$ aufgebrachten Leistungspulses, und ähnlicher Weise $t_2$ ist die Pulszeit des während der gleichen Periode T auf die zweite Teilkathode $T_2$ aufgebrachten Leistungspulses, und so weiter, wobei die Pulszeit $t_i$, in diesem Beispiel mit i =1 bis 6, so ausgewählt wurde, dass $t_1 = t_2 = t_3 = t_4 = t_5 = t_6$. Die zeitliche Abfolge der Übergabe der Sputterleistung von einem Target (Sputterkathode in diesem Kontext) zum anderen erfolgt wie oben bereits erwähnt ohne Unterbrechung der aus Generator Sicht gelieferten Leistung P. Die Sequenz $t_1$ bis $t_6$ wiederholt sich mit der Periodendauer T und erfolgt ebenfalls unterbrechungsfrei aus Sicht des Generators. Im Beispiel in Fig. 1 sind die Pulszeiten $t_1$ bis $t_6$ gleich lang dargestellt. Es kann jedoch jede Pulszeit $t_i$ einer Teilkathode $T_i$ individuell eingestellt werden.

- Figur 2 zeigt den Verlauf der spezifischen Beschichtungsrate von Titan abhängig von der Sputterleistungsdichte.

- Figur 3 zeigt den Verlauf der Beschichtungsrate in Abhängigkeit der Sputterleistungsdichte gemäss der Sputter-Anordnung mit 6 Teilkathoden, wie in Fig. 1 dargestellt, unter Einbeziehung der spezifischen Beschichtungsrate von Titan in Abhängigkeit der Sputterleistungsdichte.

- Figur 4 (umfasst Fig. 4a und 4b) zeigt eine Ausführungsform einer Sputter-Anordnung gemäss der vorliegenden Erfindung mit einer erfindungsgemässen Vernetzung von Sputtergeneratoren (Fig. 4a), welche sinngemäss verschaltet sind, um eine zugehörige, zeitliche Verteilung der Sputterleistungspulse zu ermöglichen, wobei die Puls- leistung ist jeweils $P = P_1+P_2+P_3+P_4+P_5+P_6$ und die Sputterleistungspulse werden auf die jeweiligen Teilkathoden $T_i$ während einer entsprechenden Pulszeit $t_i$ aufgebracht, d.h. auf die Teilkathode $T_1$ während einer Pulszeit $t_1$, auf die Teilkathode $T_2$ während einer Pulszeit $t_2$, usw. (Fig. 4b).

- Figur 5 (umfasst Fig. 5a und 5b) zeigt die gleiche Ausführungsform einer Sputter-Anordnung gemäss der vorliegenden Erfindung wie in Fig. 4, aber in einer weiteren erfindungsgemässen Verschaltung (Fig. 5a), welche es ermöglicht, die Sputter-Anordnung gleichzeitig in zwei unterschiedlichen Sputter-Sub-Anordnungen A und B zu betreiben. Fig. 5b zeigt die entsprechende zeitliche Verteilung der Leistungspulse in den Sputter-Sub-Anordnungen, wobei die Leistung in der Sub-Anordnung A ist $P_A=P_1+P_2+P_3$ und die Leistung in der Sub-Anordnung B ist $P_B=P_4+P_5+P_6$.

- Figur 6 (umfasst Fig. 6a und 6b) zeigt die gleiche Ausführungsform einer Sputter-Anordnung gemäss der vorliegenden Erfindung wie in Fig. 4 und Fig. 5, aber in einer weiteren erfindungsgemässen Verschaltung (Fig. 6a), bei der keine Leistungspulse mehr generiert werden, sondern die jeweiligen Sputterkathoden kontinuierlich mit der Leistung der jeweiligen Sputterleistungsgeneratoren $G_1$ bis $G_6$ getrennt gespeist werden, wie in Fig. 6b gezeigt ist.

- Figur 7 zeigt den Beschichtungsratengewinn bei Umschaltung der erfindungsgemässen Sputter-Anordnung von der Verschaltung in Fig. 4 auf die Verschaltung in Fig. 5.

Konkret offenbart die vorliegende Erfindung:

- Eine Sputter-Anordnung mit einer Anzahl N von Sputterkathoden oder Teilkathoden $T_i$ mit i = 1 bis N, und einer Anzahl n von Sputterleistungsgeneratoren $G_j$ mit j = 1 bis n, wobei N eine ganze Zahl ist und $N \geq 2$ und n auch eine ganze Zahl ist und $n \geq 2$, wobei die Sputter-Anordnung Brückenschalter $Sb_j$ zur Schaltung der Leistungsausgabe $P_j$ des jeweiligen Sputterleistungsgenerators $G_j$, und Pulsschalter $Sp_i$ zur Verteilung der jeweiligen Leistungsaus- gaben $P_j$ auf die jeweiligen Sputterkathoden $T_i$, umfasst, wobei die Sputter-Anordnung so zusammengebaut ist, dass sie zumindest in zwei verschiedenen Verschaltungsmöglichkeiten betreibbar ist, wobei:

- bei der ersten Verschaltungsvariante die jeweiligen Leistungsausgaben $P_j$ der n-Sputterleistungsgeneratoren $G_j$ sinngemäß durch die Brückenschalter so verschaltet werden können, dass eine gesamte Sputterleistung P

$$P = \sum_{j=1}^{n} P_j,$$

zur Verfügung gestellt wird, welche der Summe der Leistungsausgaben $P_j$ entspricht, d.h.
und wobei im Betrieb über eine Pulssequenzerzeugung durch die jeweiligen Pulsschalter eine Sequenz von Leistungspulse mit Pulsleistung P und Sequenzperiode T erzeugt wird, wobei im Betrieb die einzelnen Leistungspulsen auf die jeweiligen Sputterkathoden $T_i$ zeitlich verteilt werden, und wobei im Betrieb die Sputterkathoden jeweils während einer Pulszeit $t_i$ gespeist werden und eine Periode T der Summe der Pulszeiten ent-

$$T = \sum_{i=1}^{N} t_i,$$

spricht, d.h. und

- bei der zweiten Verschaltungsvariante die Sputterkathoden zumindest in zwei separaten Sputter-Sub-Anordnungen A und B verschaltet sind, wobei zum Betrieb der Sputter-Sub-Anordnungen jeweils die Leistungsausgaben von einer Anzahl nA der Sputtergeneratoren und einer Anzahl nB der Sputtergeneratoren sinngemäß durch die Brückenschalter so verschaltet sind, dass eine erste Pulsleistung $P_A = \sum_{j=1}^{nA} P_j$ und eine zweite Pulsleistung $P_B = \sum_{j=nA}^{n} P_j$ zur Verfügung gestellt wird, mit nA + nB = n, und wobei im Betrieb über jeweilige Pulssequenzerzeugungen durch die jeweiligen Pulsschalter jeweils eine erste Sequenz von Leistungspulsen mit Pulsleistung $P_A$ und Sequenzperiode $T_A$ und eine zweite Sequenz von Leistungspulsen mit Pulsleistung $P_B$ und Sequenzperiode $T_B$ erzeugt werden, wobei im Betrieb die einzelnen Leistungspulse auf die Sputterkathoden der jeweiligen Sputtern-Sub-Anordnungen zeitlich verteilt werden, wobei NA der Anzahl der Sputterkathoden der ersten Sputter-Sub-Anordnung A und NB die Anzahl der Sputterkathoden der zweiten Sputter-Sub-Anordnung B entspricht und NA +NB = N, und wobei die Sequenzperiode $T_A$ der Summe der Pulszeiten für die Sputterkathoden der ersten Sputter-Sub-Anordnung A und die Sequenzperiode $T_B$ der Summe der Pulszeiten für die Sputterkathoden der zweiten Sputtern-Sub-Anordnung B entspricht, d.h.

$$T_A = \sum_{i=1}^{NA} t_i \text{ und}$$

$$T_B = \sum_{i-NA}^{N} t_i.$$

- Eine Vakuumbeschichtungsanlage mit einer erfinderischen Sputter-Anordnung wie oben beschrieben, wobei die Sputter-Anordnung dergestalt zusammengebaut ist, dass während der Durchführung eines Sputter-Verfahrens hohe Leistungspulse eingesetzt werden können, welche die Anwendung von hohen Sputterleistungsdichten von 100 W/cm2 oder grösser, insbesondere von 300 W/cm2 oder grösser, ermöglichen.

- Eine Vakuumbeschichtungsanlage wie oben beschrieben, in der vorzugsweise N = n.

- Eine Vakuumbeschichtungsanlage wie oben beschrieben, in der vorzugsweise $P_A = P_B$.

- Eine Vakuumbeschichtungsanlage wie oben beschreiben, in der vorzugsweise $P = P_A + P_B$.

- Eine Vakuumbeschichtungsanlage wie oben beschrieben, in der vorzugsweise NA = NB und/oder nA = nB.

- Eine Methode zum Beschichten von Substraten mittels HiPIMS, wobei das HiPIMS-Verfahren in einer Vakuumbeschichtungsanlage wie in einer der oben beschriebenen, erfinderischen Vakuumbeschichtungsanlagen durchgeführt wird.

- Eine Methode wie oben beschrieben, wobei zumindest zur Abscheidung einer Schicht mittels HiPIMS-Verfahren die Sputter-Anordnung auf eine

Verschaltungsvariante mit zumindest zwei Sputter-Sub-Anordnungen umgeschaltet wird, wobei ein Beschichtungsrategewinn im Vergleich mit einem HiPIMS-Verfahren, welches mit der Sputter-Anordnung bei einer ersten Verschaltungsvariante durchgeführt würde, erreicht wird.

**Patentansprüche**

1. Sputter-Anordnung, wobei die Sputter-Anordnung eine Anzahl N von Sputterkathoden oder Teilkathoden $T_i$ mit i = 1 bis N, und einer Anzahl n von Sputterleistungsgeneratoren $G_j$ mit j = 1 bis n umfasst, wobei N eine ganze Zahl ist und $N \geq 2$ und n auch eine ganze Zahl ist und $n \geq 2$, wobei die Sputter-Anordnung Brückenschalter $Sb_j$ zur Schaltung der Leistungsausgabe $P_j$ des jeweiligen Sputterleistungsgenerators $G_j$, und Pulsschalter $Sp_i$ zur Verteilung der jeweiligen Leistungsausgaben $P_j$ auf die jeweiligen Sputterkathoden T umfasst, wobei die Sputter-Anordnung so zusammengebaut ist, dass sie zumindest in zwei verschiedenen Verschaltungsmöglichkeiten betreibbar ist, wobei:

• bei der ersten Verschaltungsvariante die jeweiligen Leistungsausgaben $P_j$ der n-Sputterleistungsgeneratoren $G_j$ sinngemäß durch die Brückenschalter so verschaltet sind, dass eine gesamte Sputterleistung P zur Verfügung

$$P = \sum_{j=1}^{n} P_j,$$

gestellt wird, welche der Summe der Leistungsausgaben $P_j$ entspricht, d.h. und wobei im Betrieb, über eine Pulssequenzerzeugung durch die jeweiligen Pulsschalter eine Sequenz von Leistungspulsen mit Pulsleistung P und Sequenzperiode T erzeugt wird, wobei im Betrieb, die einzelnen Leistungspulse auf die jeweiligen Sputterkathoden $T_i$ zeitlich verteilt werden, und wobei im Betrieb, die Sputterkathoden jeweils während

einer Pulszeit $t_i$ gespeist werden und eine Periode T der Summe der Pulszeiten entspricht, d.h. $T = \sum_{i=1}^{N} t_i,$ und **dadurch gekennzeichnet dass**

• bei der zweiten Verschaltungsvariante die Sputterkathoden zumindest in zwei separaten Sputter-Sub-Anordnungen A und B verschaltet sind, wobei zum Betrieb der Sputter-Sub-Anordnungen jeweils die Leistungsausgaben von einer Anzahl nA der Sputtergeneratoren und einer Anzahl nB der Sputtergeneratoren sinngemäß durch die Brückenschalter so verschaltet sind, dass eine erste Pulsleistung $P_A = \sum_{j=1}^{nA} P_j$ und eine zweite Pulsleistung $P_B = \sum_{j=nA}^{n} P_j$ zur Verfügung gestellt wird, mit nA + nB = n, und wobei im Betrieb über jeweilige Pulssequenzerzeugungen durch die jeweiligen Pulsschalter jeweils eine erste Sequenz von Leistungspulsen mit Pulsleistung $P_A$ und Sequenzperiode $T_A$ und eine zweite Sequenz von Leistungspulsen mit Pulsleistung $P_B$ und Sequenzperiode $T_B$ erzeugt werden, wobei im Betrieb die einzelnen Leistungspulse auf die Sputterkathoden der jeweiligen Sputter-Sub- Anordnungen zeitlich verteilt werden, wobei NA der Anzahl der Sputterkathoden der ersten Sputter-Sub-Anordnung A und NB der Anzahl der Sputterkathoden der zweiten Sputter-Sub-Anordnung B entspricht und NA +NB = N, und wobei die Sequenzperiode $T_A$ die Summe der Pulszeiten für die Sputterkathoden der ersten Sputter-Sub-Anordnung A und die Sequenzperiode $T_B$ der Summe der Pulszeiten für die Sputterkathoden der zweiten Sputter-Sub-Anordnung B entspricht, d.h. $T_A = \sum_{i=1}^{NA} t_i$ und

$T_B = \sum_{i=NA}^{N} t_i.$

2. Vakuumbeschichtungsanlage mit einer Sputter-Anordnung nach Anspruch 1 , **dadurch gekennzeichnet, dass** die Sputter-Anordnung dergestalt zusammengebaut ist, dass während der Durchführung eines Sputter-Verfahrens hohe Leistungspulse eingesetzt werden können, welche die Anwendung von hohen Sputterleistungsdichten von 100 W/cm2 oder grösser, insbesondere von 300 W/cm2 oder grösser, ermöglichen.

3. Vakuumbeschichtungsanlage nach Anspruch 1 oder 2, **dadurch gekennzeichnet, dass** N = n ist.

4. Vakuumbeschichtungsanlage nach einem der Ansprüche 1 bis 3, **dadurch gekennzeichnet, dass** $P_A = P_B$ ist.

5. Vakuumbeschichtungsanlage nach einem der Ansprüche 1 bis 4, **dadurch gekennzeichnet, dass** P = $P_A$ + $P_B$ ist.

6. Vakuumbeschichtungsanlage nach einem der Ansprüche 1 bis 5, **dadurch gekennzeichnet, dass** NA = NB und/oder nA = nB ist.

7. Methode zum Beschichten von Substraten mittels HiPIMS, wobei das HiPIMS-Verfahren in einer Vakuumbeschichtungsanlage mit einer Sputter-Anordnung durchgeführt wird, wobei die Sputter-Anordnung eine Anzahl N von Sputterkathoden oder Teilkathoden $T_i$ mit i = 1 bis N, und eine Anzahl n von Sputterleistungsgeneratoren $G_j$ mit j = 1 bis n umfasst, **dadurch gekennzeichnet, dass** N ist eine ganze Zahl und N $\geq$ 2 und n ist auch eine ganze Zahl und n $\geq$ 2, wobei die Sputter-Anordnung Brückenschalter $Sb_j$ zur Schaltung der Leistungsausgabe $P_j$ des jeweiligen Sputterleistungsgenerators $G_j$, und Pulsschalter $Sp_i$ zur Verteilung der jeweiligen Leistungsausgaben $P_j$ auf die jeweiligen Sputterkathoden T umfasst, wobei die Sputter-Anordnung so zusammengebaut ist, dass sie zumindest in zwei verschiedenen Verschaltungsmöglichkeiten betrieben werden kann, wobei:

• bei der ersten Verschaltungsvariante die jeweiligen Leistungsausgaben $P_j$ der n-Sputterleistungsgeneratoren $G_j$ sinngemäß durch die Brückenschalter so verschaltet werden können, dass eine gesamte Sputterleistung P

$$P = \sum_{j=1}^{n} P_j,$$

zur Verfügung gestellt wird, welche der Summe der Leistungsausgaben $P_j$ entspricht, d.h. und wobei über eine Pulssequenzerzeugung durch die jeweiligen Pulsschalter eine Sequenz von Leistungspulsen mit Pulsleistung P und Sequenzperiode T erzeugt wird, wobei die einzelnen Leistungspulse auf die jeweiligen Sputterkathoden $T_i$ zeitlich verteilt werden, wobei die Sputterkathoden jeweils während einer Pulszeit

$t_i$ gespeist werden und eine Periode T der Summe der Pulszeiten entspricht, d.h. $T = \sum_{i=1}^{N} t_i,$ und **gekennzeichnet dadurch, dass**

• bei der zweiten Verschaltungsvariante die Sputterkathoden zumindest in zwei separaten Sputter-Sub-Anordnungen A und B betrieben werden, wobei zum Betrieb der Sputter-Sub-Anordnungen jeweils die Leistungsausgaben von einer Anzahl nA der Sputtergeneratoren und einer Anzahl nB der Sputtergeneratoren sinngemäß

$$P_A = \sum_{j=1}^{nA} P_j$$

durch die Brückenschalter so verschaltet werden können, dass eine erste Pulsleistung und

eine zweite Pulsleistung $P_B = \sum_{j=nA}^{n} P_j$ zur Verfügung gestellt wird, mit nA + nB = n, und wobei über jeweilige Pulssequenzerzeugungen durch die jeweiligen Pulsschalter jeweils eine erste Sequenz von Leistungspulsen mit Pulsleistung $P_A$ und Sequenzperiode $T_A$ und eine zweite Sequenz von Leistungspulsen mit Pulsleistung $P_B$ und Sequenzperiode $T_B$ erzeugt werden, wobei die einzelnen Leistungspulse auf die Sputterkathoden der jeweiligen Sputter-Sub-Anordnungen zeitlich verteilt werden, wobei NA der Anzahl der Sputterkathoden der ersten Sputter-Sub-Anordnung A und NB der Anzahl der Sputterkathoden der zweiten Sputter-Sub-Anordnung B entspricht und NA +NB = N, und wobei die Sequenzperiode $T_A$ der Summe der Pulszeiten für die Sputterkathoden der ersten Sputter-Sub-Anordnung A und die Sequenzperiode $T_B$ der Summe der Pulszeiten für die Sputterkathoden der zweiten Sputter-Sub-Anordnung B entspricht, d.h. $T_A =$

$$\sum_{i=1}^{NA} t_i \text{ und } T_B = \sum_{i=NA}^{N} t_i.$$

8. Methode nach Anspruch 7, **dadurch gekennzeichnet, dass** zumindest zur Abscheidung einer Schicht mittels HiPIMS-Verfahren die Sputter-Anordnung auf eine Verschaltungsvariante mit zumindest zwei Sputter-Sub-Anordnungen umgeschaltet wird, wobei ein Beschichtungsrategewinn im Vergleich mit einem HiPIMS-Verfahren, welches mit der Sputter Anordnung bei einer ersten Verschaltungsvariante durchgeführt würde, erreicht wird.

9. Methode nach Anspruch 7 oder 8, **dadurch gekennzeichnet, dass** die Sputter-Anordnung dergestalt zusammengebaut ist, dass während der Durchführung eines Sputter-Verfahrens hohe Leistungspulse eingesetzt werden können, welche die Anwendung von hohen Sputterleistungsdichten von 100 W/cm2 oder grösser, insbesondere von 300 W/cm2 oder grösser, ermöglichen.

10. Methode nach einem der Ansprüche 7 bis 9, **dadurch gekennzeichnet, dass** N = n ist.

11. Methode nach einem der Ansprüche 7 bis 10, **dadurch gekennzeichnet, dass** $P_A = P_B$ ist.

12. Methode nach einem der Ansprüche 7 bis 11, **dadurch gekennzeichnet, dass** P = $P_A$ + $P_B$ ist.

13. Methode nach einem der Ansprüche 7 bis 12, **dadurch gekennzeichnet, dass** NA = NB und/oder nA = nB ist.

**Claims**

1. A sputtering arrangement, wherein the sputtering arrangement comprises a number N of sputtering cathodes or partial cathodes $T_i$ with i=1 to N, and a number n of sputtering power generators $G_j$ with j=1 to n, wherein N is a whole number and N ≥ 2 and n is also a whole number and n ≥ 2; wherein the sputtering arrangement comprises bridge switches $Sb_j$ for switching the power output $P_j$ of the respective sputtering power generator $G_j$, and pulse switches $Sp_i$ for distributing the respective power outputs $P_j$ to the respective sputtering cathodes $T_i$, wherein the sputtering arrangement is assembled so that it can be operated in at least two different interconnection possibilities, wherein:

   - in the first interconnection variant, the respective power outputs $P_j$ of the n sputtering power generators $G_j$ are logically interconnected by means of the bridge switches so that a total sputtering power P is supplied, which

   $$P = \sum_{j=1}^{n} P_j$$

   corresponds to the sum of the power outputs $P_j$, i.e. and wherein, during operation, through a pulse sequence generation by means of the respective pulse switches, a sequence of power pulses with pulse power P and sequence period T is produced; wherein during operation the individual power pulses are chronologically distributed to the respective sputtering cathodes $T_i$, and wherein during operation the sputtering cathodes are respectively supplied with power during a pulse time $t_i$; and a period T corresponds to the sum of

   $$T = \sum_{i=1}^{N} t_i$$

   the pulse times, i.e. and thus **characterized in that**
   - in the second interconnection variant, the sputtering cathodes are interconnected in at least two separate sputtering sub-arrangements A and B, wherein, in order to operate the sputtering sub-arrangements, the respective power outputs of a number nA of sputtering generators and a number nB of sputtering generators are

   $$P_A = \sum_{j=1}^{nA} P_j$$

   logically interconnected by means of the bridge switches so that a first pulse power and a

   $$P_B = \sum_{j=nA}^{n} P_j$$

   second pulse power are supplied, wherein nA+nB=n, and wherein during operation through the respective generation of pulse sequence by means of the respective pulse switches, a first sequence of power pulses with a pulse power $P_A$ and a sequence period $T_A$ and a second sequence of power pulses with a pulse power $P_B$ and a sequence period $T_B$ are produced respectively, wherein during operation the individual power pulses are chronologically distributed to the sputtering cathodes of the respective sputtering sub-arrangements, wherein NA corresponds to the number of sputtering cathodes of the first sputtering sub-arrangement A and NB corresponds to the number of sputtering cathodes of the second sputtering sub-arrangement B and NA+NB=N, and wherein the sequence period $T_A$ corresponds to the sum of the pulse times for the sputtering cathodes of the first sputtering sub-arrangement A and the sequence period $T_B$ corresponds to the sum of the pulse times for the sputtering cathodes of the second sputtering sub-arrangement B, i.e. $T_A = \sum_{i=1}^{NA} t_i$ and

   $T_B = \sum_{i=NA}^{N} t_i$.

2. A vacuum coating system with a sputtering arrangement according to claim 1, **characterized in that** the sputtering arrangement is assembled in such a way that during the execution of a sputtering method, high power pulses can be used, which permit the use of high sputtering power densities of 100 W/cm$^2$ or greater, in particular 300 W/cm$^2$ or greater.

3. The vacuum coating system according to claim 1 or 2, **characterized in that** N = n.

4. The vacuum coating system according to one of the claims 1 to 3, **characterized in that** $P_A = P_B$.

5. The vacuum coating system according to one of the claims 1 to 4, **characterized in that** P = $P_A$ + $P_B$.

6. The vacuum coating system according to one of the claims 1 to 5, **characterized in that** NA = NB and/or nA = nB.

7. A method for coating substrates by means of HiPIMS, wherein the HiPIMS method is carried out in a vacuum coating system by means of a sputtering arrangement,
wherein the sputtering arrangement comprises a number N of sputtering cathodes or partial cathodes $T_i$ with i = 1 to N, and a number n of sputtering power generators $G_j$ with j = 1 to n, **characterized in that** N is a whole number and N $\geq$ 2 and n is also a whole number and n $\geq$ 2; wherein the sputtering arrangement comprises bridge switches $Sb_j$ for switching the power output $P_j$ of the respective sputtering power generator $G_j$, and pulse switches $Sp_i$ for distributing the respective power outputs $P_j$ to the respective sputtering cathodes $T_i$, wherein the sputtering arrangement is assembled so that it can be operated in at least two different interconnection possibilities, wherein:

- in the first interconnection variant, the respective power outputs $P_j$ of the n sputtering power generators $G_j$ are logically interconnected by means of the bridge switches so that a total sputtering power P is supplied, which

$$P = \sum_{j=1}^{n} P_j$$

corresponds to the sum of the power outputs $P_j$, i.e. and wherein, through a pulse sequence generation by means of the respective pulse switches, a sequence of power pulses with pulse power P and sequence period T is produced; wherein the individual power pulses are chronologically distributed to the respective sputtering cathodes $T_i$, wherein the sputtering cathodes are respectively supplied with power during

$$T = \sum_{i=1}^{N} t_i$$

a pulse time $t_i$ and a period T corresponds to the sum of the pulse times, i.e. and thus **characterized in that**
- in the second interconnection variant, the sputtering cathodes are interconnected in at least two separate sputtering sub-arrangements A and B, wherein, in order to operate the sputtering sub-arrangements, the respective power outputs of a number nA of sputtering generators and a number nB of sputtering generators can

$$P_A = \sum_{j=1}^{nA} P_j$$

be logically interconnected by means of the bridge switches so that a first pulse power and a second pulse power

$$P_B = \sum_{j=nA}^{n} P_j$$

are supplied, wherein nA+nB=n, and wherein through the respective generation of pulse sequence by means of the respective pulse switches, a first sequence of power pulses with a pulse power $P_A$ and a sequence period $T_A$ and a second sequence of power pulses with a pulse power $P_B$ and a sequence period $T_B$ are produced respectively, wherein the individual power pulses are chronologically distributed to the sputtering cathodes of the respective sputtering sub-arrangements, wherein NA corresponds to the number of sputtering cathodes of the first sputtering sub-arrangement A and NB corresponds to the number of sputtering cathodes of the second sputtering sub-arrangement B and NA+NB=N, and wherein the sequence period $T_A$ corresponds to the sum of the pulse times for the sputtering cathodes of the first sputtering sub-arrangement A and the sequence period $T_B$ corresponds to the sum of the pulse times for the sputtering cathodes of the second sputtering sub-arrangement B, i.e. $T_A = \sum_{i=1}^{NA} t_i$ and $T_B = \sum_{i=NA}^{N} t_i$.

8. The method according to claim 7, **characterized in that** at least in order to deposit a layer by means of HiPIMS methods, the sputtering arrangement is switched to an interconnection variant with at least two sputtering sub-arrangements, wherein a coating rate gain is achieved in comparison to a HiPIMS method, which is carried out with the sputtering arrangement in a first interconnection variant.

9. The method according to claim 7 or 8, **characterized in that** the sputtering arrangement is assembled in such a way that during the execution of a sputtering method, high power pulses can be used, which permit the use of high sputtering power densities of 100 W/cm$^2$ or greater, in particular 300 W/cm$^2$ or greater.

10. The method according to one of the claims 7 to 9, **characterized in that** N = n.

**11.** The method according to one of the claims 7 to 10, **characterized in that** $P_A=P_B$.

**12.** The method according to one of the claims 7 to 11, **characterized in that** $P = P_A + P_B$.

**13.** The method according to one of the claims 7 to 12, **characterized in that** NA = NB and/or nA = nB.

**Revendications**

**1.** Système de pulvérisation cathodique, le système de pulvérisation cathodique comprenant un nombre N de cathodes de pulvérisation ou de cathodes partielles de pulvérisation $T_i$ avec i = 1 à N, et un nombre n de générateurs de puissance de pulvérisation $G_j$ avec j = 1 à n, N étant un nombre entier et N $\geq$ 2 et n étant également un nombre entier et n $\geq$ 2; le système de pulvérisation cathodique comprenant des commutateurs en pont $Sb_j$ pour commuter les sorties de puissance $P_j$ du générateur de puissance de pulvérisation respectif $G_j$, et des commutateurs à impulsion $Sp_i$ pour distribuer les sorties de puissance respectives $P_j$ aux cathodes de pulvérisation respectives T; le système de pulvérisation cathodique étant assemblé de manière à pouvoir fonctionner dans au moins deux variantes d'interconnexion différentes:

- pour la première variante d'interconnexion, les sorties de puissance respectives $P_j$ des n générateurs de puissance de pulvérisation $G_j$ sont logiquement interconnectées au moyen des commutateurs en pont de sorte qu'une puissance totale de pulvérisation P est fournie, qui correspond à la somme des sorties de puissance

$$P = \sum_{j=1}^{n} P_j,$$

$P_j$, c'est-à-dire et, via une génération de séquence pulsée au moyen des commutateurs à impulsions respectifs, une séquence d'impulsions de puissance ayant une puissance pulsée P et une période de séquence T est produite pendant le fonctionnement; les impulsions de puissance individuelles étant réparties temporellement pendant le fonctionnement aux cathodes de pulvérisation $T_i$ respectives, et, pendant le fonctionnement, chacune des cathodes de pulvérisation étant alimentée en énergie pendant une durée d'impulsion

$t_i$ et une période T correspondant à la somme des durées d'impulsion, c'est-à-dire $T = \sum_{i=1}^{N} t_i,$ et **caractérisé par le fait que**

- pour la seconde variante d'interconnexion, les cathodes de pulvérisation sont interconnectées du moins dans deux sous-systèmes de pulvérisation cathodique séparés A et B, pour faire fonctionner les sous-systèmes de pulvérisation cathodique les sorties de puissance d'un certain nombre nA de générateurs de pulvérisation cathodique et d'un certain nombre nB de générateurs de pulvérisation cathodique étant logiquement interconnectées au moyen des commutateurs en pont de sorte qu'une première puissance pulsée

$$P_A = \sum_{j=1}^{nA} P_j \qquad P_B = \sum_{j=nA}^{n} P_j$$

et une seconde puissance pulsée sont fournies, avec nA + nB = n, et, pendant le fonctionnement, via la génération de séquences d'impulsions respectives au moyen des commutateurs à impulsion respectifs, une première séquence d'impulsions de puissance ayant une puissance pulsée $P_A$ et une période de séquence $T_A$ et une seconde séquence d'impulsions de puissance ayant une puissance pulsée $P_B$ et une période de séquence $T_B$ étant produites, les impulsions de puissance individuelles étant reparties temporellement pendant le fonctionnement aux cathodes de pulvérisation des sous-systèmes de pulvérisation cathodique respectifs, NA correspondant au nombre de cathodes de pulvérisation du premier sous-système de pulvérisation cathodique A et NB correspondant au nombre de cathodes de pulvérisation du second sous-système de pulvérisation cathodique B et NA + NB = N, et la période de séquence $T_A$ correspondant à la somme des durées d'impulsion pour les cathodes de pulvérisation du premier sous-système de pulvérisation cathodique A et la période de séquence $T_B$ correspondant à la somme des durées d'impulsion pour les cathodes de pulvérisation du deuxième sous-système de pulvérisation cathodique B, c'est-à-dire $T_A = \sum_{i=1}^{NA} t_i$ et $T_B = \sum_{i=NA}^{N} t_i.$

**2.** Installation de revêtement sous vide avec un système de pulvérisation cathodique selon la revendication 1, **caractérisée en ce que** le système de pulvérisation cathodique est assemblé de telle manière que, lors de l'exécution d'un procédé de pulvérisation cathodique, des impulsions de puissance élevée peuvent être utilisées, ce qui permet, lors de la pulvérisation cathodique, l'utilisation de densités de puissance élevée de 100 W/cm2 ou plus, en particulier 300 W/cm2 ou plus.

**3.** Installation de revêtement sous vide selon la revendication 1 ou 2, **caractérisée en ce que** N = n.

**4.** Installation de revêtement sous vide selon l'une des revendications 1 à 3, **caractérisée en ce que** PA = PB.

**5.** Installation de revêtement sous vide selon l'une des revendications 1 à 4, **caractérisée en ce que** P = PA + PB.

**6.** Installation de revêtement sous vide selon l'une des revendications 1 à 5, **caractérisé en ce que** NA = NB et/ou nA = nB.

**7.** Procédé de revêtir des substrats au moyen de HiPIMS, le procédé HiPIMS étant réalisé dans une installation de revêtement sous vide avec un système de pulvérisation cathodique,
le système de pulvérisation cathodique comprenant un nombre N de cathodes de pulvérisation ou de cathodes partielles de pulvérisation $T_i$ avec i = 1 à N, et un nombre n de générateurs de puissance de pulvérisation $G_j$ avec j = 1 à n, N étant un nombre entier et $N \geq 2$ et n étant également un nombre entier et $n \geq 2$; le système de pulvérisation cathodique comprenant des commutateurs en pont $Sb_j$ pour commuter les sorties de puissance $P_j$ du générateur de puissance de pulvérisation respectif $G_j$, et des commutateurs à impulsion $Sp_i$ pour distribuer les sorties de puissance respectives $P_j$ aux cathodes de pulvérisation respectives T; le système de pulvérisation cathodique étant assemblé de manière à pouvoir fonctionner dans au moins deux variantes d'interconnexion différentes:

- pour la première variante d'interconnexion, les sorties de puissance respectives $P_j$ des n générateurs de puissance de pulvérisation $G_j$ sont logiquement interconnectées au moyen des commutateurs en pont de sorte qu'une puissance totale de pulvérisation P est fournie, qui correspond à la somme des sorties de puissance

$P_j$, c'est-à-dire $P = \sum_{j=1}^{n} P_j,$ et, via une génération de séquence pulsée au moyen des commutateurs à impulsions respectifs, une séquence d'impulsions de puissance ayant une puissance pulsée P et une période de séquence T est produite; les impulsions de puissance individuelles étant réparties temporellement aux cathodes de pulvérisation $T_i$ respectives, chacune des cathodes de pulvérisation étant alimentée en énergie pendant une durée d'impulsion $t_i$ et une période T correspondant à la somme des durées d'impulsion, c'est-à-dire $T = \sum_{i=1}^{N} t_i,$ et **caractérisé par le fait que**
- pour la seconde variante d'interconnexion, les cathodes de pulvérisation fonctionnent du moins dans deux sous-systèmes de pulvérisation cathodique séparés A et B, pour faire fonctionner les sous-systèmes de pulvérisation cathodique les sorties de puissance d'un certain nombre nA de générateurs de pulvérisation cathodique et d'un certain nombre nB de générateurs de pulvérisation cathodique étant logiquement interconnectées au moyen des commutateurs en pont de sorte qu'une première puissance pulsée $P_A = \sum_{j=1}^{nA} P_j$ et une seconde puissance pulsée $P_B = \sum_{j=nA}^{n} P_j$ sont fournies, avec nA + nB = n, et, via la génération de séquences pulsées respectives au moyen des commutateurs à impulsion respectifs, une première séquence d'impulsions de puissance ayant une puissance pulsée $P_A$ et une période de séquence $T_A$ et une seconde séquence d'impulsions de puissance ayant une puissance pulsée $P_B$ et une période de séquence $T_B$ étant produites, les impulsions de puissance individuelles étant reparties temporellement aux cathodes de pulvérisation des sous-systèmes de pulvérisation cathodique respectifs, NA correspondant au nombre de cathodes de pulvérisation du premier sous-système de pulvérisation cathodique A et NB correspondant au nombre de cathodes de pulvérisation du second sous-système de pulvérisation cathodique B et NA + NB = N, et la période de séquence $T_A$ correspondant à la somme des durées d'impulsion pour les cathodes de pulvérisation du premier sous-système de pulvérisation cathodique A et la période de séquence $T_B$ correspondant à la somme des durées d'impulsion pour les cathodes de pulvérisation du deuxième sous-système de pulvérisation cathodique B, c'est-à-dire $T_A = \sum_{i=1}^{NA} t_i$ et $T_B = \sum_{i=NA}^{N} t_i$.

8. Procédé selon la revendication 7, **caractérisé en ce qu'**au moins pour déposer une couche au moyen de procédés HiPIMS, le système de pulvérisation cathodique est commuté sur une variante d'interconnexion avec au moins deux sous-systèmes de pulvérisation cathodique, un gain du taux de revêtement étant atteint par rapport à un procédé HiPIMS qui est réalisé au moyen du système de pulvérisation cathodique d'une première variante d'interconnexion.

9. Procédé selon la revendication 7 ou 8, **caractérisé en ce que** le système de pulvérisation cathodique est assemblé de telle manière que pendant l'exécution d'un procédé de pulvérisation cathodique, des impulsions de puissance élevée peuvent être utilisées, ce qui permet l'utilisation de densités de puissance élevée de 100 W/cm2 ou plus, en particulier 300 W/cm2 ou plus, lors de la pulvérisation cathodique.

10. Procédé selon l'une des revendications 7 à 9, **caractérisé en ce que** N = n.

11. Procédé selon l'une des revendications 7 à 10, **caractérisé en ce que** $P_A = P_B$.

12. Procédé selon l'une des revendications 7 à 11, **caractérisé en ce que** $P = P_A + P_B$.

13. Procédé selon l'une des revendications 7 à 12, **caractérisé en ce que** NA = NB et/ou nA = nB.

Dauer der Abgabe der Leistung P durch den Leistungsgenerator G

Figur 1

Figur 2

Figur 3

Figur 4a

*Dauer der Abgabe der Leistung P = P₁+P₂+P₃+P₄+P₅+P₆*

*durch die Leistungsgeneratoren G₁ bis G₆*

Figur 4b

Figur 5a

$T_A$   $T_A$

$t_i$

$T_1$   $t_1$   $t_1$

$T_2$   $t_2$   $t_2$

$T_3$   $t_3$   $t_3$

Dauer der Abgabe der Leistung $P_A = P_1 + P_2 + P_3$

durch die Leistungsgeneratoren $G_4$ bis $G_6$

$T_B$   $T_B$

$t_i$   $t_i$

$T_4$   $t_4$   $t_4$

$T_5$   $t_5$   $t_5$

$T_6$   $t_6$   $t_6$

Dauer der Abgabe der Leistung $P_B = P_4 + P_5 + P_6$

durch die Leistungsgeneratoren $G_4$ bis $G_6$

Figur 5b

Figur 6a

*Zeitliche Abgabe der jeweiligen Leistungen $P_1$ bis $P_6$ durch die Leistungsgeneratoren $G_1$ bis $G_6$ auf die jeweiligen Sputterkathoden T1 bis T6*

Figur 6b

Figur 7

* bei einer erfindungsgemässen Umschaltung der Sputter-Anordnung von Verschaltung in Fig. 4 auf Verschaltung in Fig. 5

**EP 3 375 006 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2272080 B1
- DE 102011018363 A1
- US 2014248100 A1
- WO 2012143091 A